Europäisches Patentamt

European Patent Office

Office européen des brevets

(11) Publication number: **0 295 425**
**A2**

# (12) EUROPEAN PATENT APPLICATION

(21) Application number: **88107498.3**

(22) Date of filing: **10.05.88**

(51) Int. Cl.⁴: **G01R 31/28**

(30) Priority: **15.06.87 US 62310**

(43) Date of publication of application:
**21.12.88 Bulletin 88/51**

(84) Designated Contracting States:
**DE FR GB**

(71) Applicant: **International Business Machines Corporation**
**Old Orchard Road**
**Armonk, N.Y. 10504(US)**

(72) Inventor: **Beh, Chao Chun**
**4 Scott Court**
**Poughpeeksie New York 12601(US)**
Inventor: **Carnell, Charles Howard**
**12 Vervalen Drive**
**Poughkeepsie New York 12603(US)**
Inventor: **Heller, William Russell**
**42 Brentwood Drive**
**Poughkeepsie New York 12603(US)**
Inventor: **Hitchcock, Robert Brewster, Sr.**
**24 Sherwood Heights**
**Wappingers Falls New York 12590(US)**
Inventor: **Motika, Franco**
**Clove Branch Road**
**Hopewell Junction New York 12533(US)**
Inventor: **Radke, Charles Edwin**
**1790 Blossom Court**
**Yorktown Heights New York 10598(US)**
Inventor: **Salvatori, Peter John**
**RD2, Crown Hill Road**
**Wappingers Falls New York 10590(US)**
Inventor: **Sharp, Elmer Marshall**
**24 Walnut Hill Road**
**Poughkeepsie New York 12603(US)**
Inventor: **Tendolkar, Nandakumar Nityananda**
**18 Sabra Lane**
**Wappingers Falls New York 12590(US)**

(74) Representative: **Bonin, Jean-Jacques**
**Compagnie IBM France Département de Propriété Intellectuelle**
**F-06610 La Gaude(FR)**

(54) Improved delay testing for high speed logic.

(57) A delay testing method for high speed logic chips is disclosed wherein a plurality of classes (types) of signal paths are specified. For each signal path class, the maximum allowable delay is determined from the circuit design and the operating parameters for that design. Then, each chip is tested using a plurality of test patterns and the delay is measured for each signal path class. If any mea-

sured delay for any signal path exceeds the maximum allowable delay for that signal path class, the chip is rejected as having a delay fault.

FIG. 2A

## IMPROVED DELAY TESTING FOR HIGH SPEED LOGIC

The present invention relates broadly to the field of semiconductor testing and more particularly to delay testing of high performance logic devices used, for example, in digital computers.

Delay testing has been used for many years by the semiconductor manufacturing industry for detecting delay faults in LSI chips. For example, delay testing of one type is disclosed in U.S. patents 4,495,628 and 4,587,480. In this approach, a shift register on the chip is operated at its maximum speed and its performance is measured. From the measurement, propagation delay for the shift register is determined and that for other circuits of the chip are inferred therefrom.

Another testing method is disclosed in U.S. patent 4,477,902. In this approach, tests are performed on the random logic component using specific strobe timing to determine if the component meets specifications. Then, the same tests are performed with differing and faster strobe timing. The data captured by the scan register is then scanned out and the results compared. A comparison failure between the first test data and the second test data indicates a component failure at the higher strobe rate.

An article discussing a different delay testing approach entitled "A Delay Test System For High Speed Logic LSI'S" appears in the Proceedings of the 23rd Design Automation Conference, paper 43.2 pages 786-790, 1986. Delay testing, as defined in the article, determines if the path delay from one circuit to another is within the specifications for the particular design. As gate to gate delay is not directly observable from pins on the chip, latch to latch delay is measured instead. Success of this comprehensive delay test technique requires first using a scan design discipline and complete design rule checking of the circuit for compliance therewith. Delay values for all measurable paths are then calculated and stored. Subsequent tests conducted on an actual component are conducted in such a way as to test each of the measurable paths and to determine if any of the paths in the actual component have delays which are different from the calculated delay. If so, the actual component is bad and should be discarded.

While the above described comprehensive delay test approach does yield good results, it does have certain limitations. One problem is in developing the delay test patterns to be used. In order to provide high reliability for the tested product, a large number of tests need to be developed to test for delay faults. This contributes to increasing the development cost for a part. In addition, these tests slow down the manufacturing of parts thereby contributing to increasing the manufacturing thereof. A second problem results from the fact that this type of test is very extensive and will locate all components not complying with the correct delay for that component. In practice, however, even components that exhibit delay test failures may function in the intended system configuration without failure as the delay which caused the failure may not be critical to system operation. As such, the delay test outlined above may reject some components which may actually be operative in the system for which they are designed which contributes further to increased manufacturing cost.

Because of these problems, the approach described immediately above is not frequently used and where used it contributes to increasing the cost of the product. By not doing such delay testing for many products, however, modules having a plurality of chips thereon are more likely to have delay faults which sometimes are referred to as AC faults. Accordingly, not doing such delay testing can contribute to increased manufacturing cost because more system failures in modules are likely to occur which will cause increased manufacturing cost due to increased module repair costs.

Accordingly, it is a primary objective of the present invention to provide a delay test method which results in a manufacturing cost impact which is lower than for a comprehensive delay test method and also lower than the manufacturing cost impact of doing no delay testing at all.

It is still another objective of the present invention to provide a delay testing method which increases the probability that a particular circuit will operate in the environment for which it is intended.

It is yet a further objective of the present invention to provide a delay testing method which produces acceptable parts rejection criteria while producing an acceptable failure rate when the parts are later tested in their intended operating environment.

Brief Description

The above mentioned and other objects advantages and features of the present invention are achieved by the present invention by providing a new chip testing method which is applicable to chips designed using either scan design or LSSD design methodology. The method involves first identifying for each chip design the maximum acceptable delay between application of a test pattern to each of a plurality of signal paths and the appearance of the last output resulting therefrom.

The classes of signal paths are selected from the following group of exemplary paths comprising: (1) the path from primary input pins to primary output pins; (2) the path from the LSSD L2 latch to a primary output pin; (3) the path from the LSSD L2 latch to an L1 LSSD latch via internal logic in the chip; (4) the path from primary input pins to an LSSD latch L1. Other paths may also be selected. Once the maximum acceptable delays for signals for each class of signal path is determined, then each chip of that design is tested using DC test patterns to determine if any of the maximum acceptable delays for each class of signal path is exceeded. Circuits having any one maximum acceptable delay being exceeded are rejected.

Brief Description of the Drawings

The above described invention having the described and other objects, advantages and features is described below in greater detail in connection with the drawings which form a part of the disclosure wherein:

Fig. 1 illustrates a typical VLSI chip with internal combinational logic, a scan register with a plurality of positions and a plurality of primary input and primary output pins;

Fig. 2A illustrates internal combinational logic which provides a path from a primary input pin to a primary output pin;

Fig. 2B illustrates the performance of a properly manufactured circuit such as found in Fig. 2A and the performance of a circuit with a delay fault;

Fig. 3A illustrates internal combinational logic disposed between a chip primary input and the L1 latch of a scan register;

Fig. 3B illustrates the timing of the signals on the signal lines of Fig. 3A;

Fig. 4A illustrates internal combinational logic disposed between the L2 latch and a primary output pin;

Fig. 4B illustrates the timing signals used in connection with Fig. 4A;

Fig. 5A illustrates the circuitry for transferring data from the L1 to the L2 latch in the scan register;

Fig. 5B illustrates the timing of signals used in the circuit of Fig. 5A;

Fig. 6A illustrates internal combinational logic disposed between latch L2 of the scan register and the L1 latch; and

Fig. 6B illustrates the timing signals used in connection with the circuit of Fig. 6A.

Detailed Description

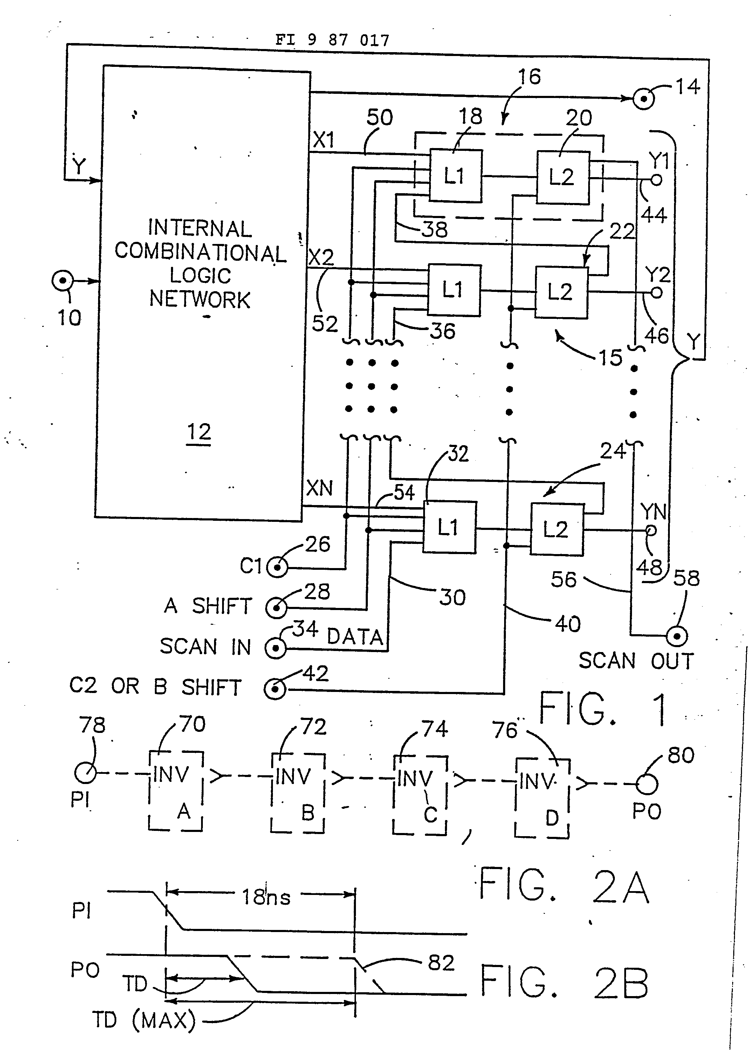

Figure 1 illustrates a typical logic configuration designed according to LSSD double latch design rules which are well known in the prior art. See, for example, U.S. patents 3,761,695 and 3,784,907. The circuitry illustrated in Fig. 1 is representative of the entire circuitry on a given chip. The chip has a plurality of primary input pins. The primary input pins include a plurality of pins such as pin 10 (other primary input pins are omitted for drawing clarity reasons) which couple directly to an internal combinational logic network 12. The logic network 12 has a plurality of primary output pins represented as a single output pin 14 for purposes of simplifying the drawing only. Although not shown, the chip may also have a plurality of common input/output pins. Those of skill in the art will recognize that contemporary chips may have one hundred or more pins thereby making possible any combination of primary input pins, primary output pins or common I/O's.

The internal combinational logic network 12 typically comprises a plurality of logic circuits coupled together in a custom fashion so as to provide a desired function for converting signals appearing at the primary input pins 10 to a different set of signals appearing at the primary output pins 14. The particular nature of the internal combinational logic network 12 is not critical to the operation of the present invention, however, it is required that the operation of the circuitry contained therein is well understood and particularly that the expected internal circuit delays are known or determinable from the actual logic design.

The circuitry of Fig. 1 is designed according to level sensitive scan design (LSSD) rules. This circuitry includes a scan register 15 having a plurality of double latches such as the double latch illustrated inside the dotted line 16. This double latch 16 includes an L1 latch 18 and an L2 latch 20. In addition, there are a plurality of other double latches in the scan register 15 such as those illustrated generally at 22 and at 24. The specific number of double latches found within a given scan register 15 is dependent on the number of circuits in the internal combinational logic network 12 and the design rules utilized in connection therewith. Such design rules will function to specify the number of double latches, such as 16, 22 and 24, which comprise the scan register 15. Some designs may include a plurality of scan registers 15.

Each of the latches L1 of the scan register 15 are coupled to a primary input such as pin 26 and to a second primary input pin such as 28. The primary input pin 26 is utilized for receiving a gate signal referred to as C1 and the primary input pin 28 is used for receiving a signal known as A shift.

In addition, each latch L1 has a scan in line, such as line 30, coupled to latch L1 32. This line 30 is coupled directly to a primary input pin 34 which is for receiving scan data from the exterior world and gating it into the chip illustrated in Fig. 1. The other L1 latches of the scan register 15 have scan in lines such as lines 36 and 38 which are coupled to the output of the L2 latch of the preceding position in the scan register 15.

The L2 latches of the scan register 15 are each coupled directly to the output of the L1 latch for the same position within the scan register 15. In addition, each L2 latch is coupled via a line 40 to a primary input pin 42 which is for receiving gating signals. By proper timing of the signals appearing at the input pins 28 and 42, and by proper timing of data presented to primary input pin 34, data can be gated into the L1 and L2 latches of the scan register having illustrated positions at 16, 22 and 24. This gating of data into the scan register 15 is well known in the prior art and need not be described further here.

Each of the L2 latches within the scan register 15 are coupled by lines, for example lines 44, 46 and 48 to selected points in the internal combinational logic network 12. In this manner, it is possible to take known data from the scan register 15 and apply it to various locations within the internal combinational logic network 12 which are not directly accessible by way of primary input pins. Accordingly, as is well known in the prior art, the internal combinational logic network 12 can be tested by the use of proper data patterns which are loaded into the scan register 15.

Each of the L1 latches within the scan register 15 is coupled via lines 50, 52 and 54 to nodes within the internal combinational logic network 12 and by proper gating of the latches L1, the status of the signals at the internal nodes within the logic network 12 can be determined as that condition is latched in the L1 latches. This data can subsequently be scanned out of the scan register 15 as the last scan register latch L2 is coupled via a line 56 to a primary output pin 58 which is for receiving data scanned out of the scan register 15. Accordingly, known data can be scanned into the scan register over line 30. This data can then be gated via the lines 44, 46 and 48 into the logic network 12 and the results ultimately scanned out over line 56 so as to be able to determine the response of the logic network 12 to the input pattern which had been scanned into the scanned register. As is well known in the prior art, by utilizing a plurality of test patterns applied to a logic network such as 12 via the scan register 15 and primary input pins, it is possible to determine whether the logic network 12 has any electrical defects.

The nature of the tests outlined above is that it primarily tests the combinational logic network 12 to determine whether the circuit is functioning according to design under dc conditions as no attempt is generally made to determine the timing of the appearance of output signals at primary output pins in response to signals being applied to primary input pins. Such timing tests are frequently referred to as ac tests or as propagation delay tests. Such ac testing has been performed under certain conditions in the past. The primary consideration with respect to the performance of such tests, however, has been the time involved in accomplishing same. As ac tests considerably add to the test time, if they are to be performed, it greatly complicates the final test of chip manufacture by greatly lengthening the time required to test the part and, if time is to be removed as a factor, greatly contributing to the cost of tester equipment as more testers are needed in order to maintain a desired manufacturing throughput. Because of such throughput and cost considerations, delay testing in the past has primarily been performed based on circuits having comparatively low density compared to the density currently achieved by VLSI manufacturing techniques. As the number of circuits has greatly increased per chip in recent years, propagation delay testing has frequently been rejected as a testing technique because of its increased cost either in testing equipment or in throughput for the manufacturing line. In doing so, however, it has become increasingly clear that chips which pass a dc test may in fact fail when such chips are placed into their intended operating environment where they must function with a plurality of other chips.

In cases familiar to the inventors of the present invention, systems are developed which contain as many as one hundred chips mounted on a module. In this environment, it has been found that while each of the chips can pass the dc test associated therewith, when these chips are assembled into modules containing up to one hundred chips, as many as about 25% of the modules may fail under actual operating conditions within the module. In such instances, history has proven that usually only one chip in the module is not functioning at its proper speed and that replacement thereof will place the module in condition for use in its normal operating environment. The time associated with determining which chip is failing and replacing same is an undesirable cost and, accordingly, it was one of the principle objects of the present invention to provide a means for greatly increasing the probability that a chip would not fail in its intended operating environment. To accomplish this objective at an acceptable cost, however, was the particular challenge. It was known, for example, that the LSSD design philosophy could be utilized to test delays associated with each pattern and those delays could be compared against the predicted delay for that pattern based on the particular circuit design involved so as to readily determine when the propagation delay for a given pattern failed. As already noted, however, this particular approach greatly contributed to the test time for the chip or, in the alternative, greatly increased the cost of the testers required in order to maintain a desired throughput. Accordingly, the known solution for the particular problem, namely, the undesirably high failure rate of modules containing multiple chips, was not acceptable.

In achieving the objectives of the present invention, it was initially decided that some means was required to utilize the test patterns which were already being used in connection with testing of parts under dc conditions. This would eliminate the cost of developing new test patterns suitable for use with delay test measurement. In addition, it was decided that propagation delays for each test pattern would not be determined. It was decided, however, that there were certain classes of signal paths and their propagation delays could be measured and that the maximum acceptable delay for each class of signal path could be determined from the particular chip design from its circuit design and layout. It should be also noted that each circuit in a class of signal paths has both its inputs and outputs externally accessible. For example, one class of signal path comprises the path from primary input pin to primary output pin. Other classes of signal paths use the LSSD scan register as an input, output or both to the signal path.

As a means for illustrating this concept, reference is now made to Fig. 2A and Fig. 2B. Fig. 2A shows a plurality of inversion circuits, 70, 72, 74 and 76 coupled in series between a primary input pin 78 and a primary output pin 80. The configuration of Fig. 2A, therefore, represents a portion of an internal combinational logic network 12 of Fig. 1. It further represents a circuit in a class of circuits in which signals applied to a primary input pin 78 will directly result in a signal appearing, after some delay, at a primary output pin 80. For example, if the signal labelled PI in Fig. 2A is applied to the primary input pin 78, the signal appearing at the primary output pin 80 will go down at a time TD thereafter which corresponds to the propagation delay of the signal from the input pin 78 to the output pin 80. If for some reason, one or more of the inversion circuits 70, 72, 74 or 76 and the wiring therebetween was defective in some manner, it might be possible that the signal appearing at the output pin 80 might be delayed as is illustrated by the dotted line 82 in Fig. 2B. This added delay may or may not be significant to producing a failure when the chip is put into its operative environment in a module containing a plurality of chips.

In accordance with the present invention, however, a maximum delay for each class of signal paths is determined based on the circuit design of the particular chip in question. For example, it might be determined for a particular chip design that the maximum acceptable delay between applying a signal to a primary input and until a signal resulting therefrom appears at a primary output pin is 18 ns. Such a maximum acceptable delay would clearly be for a circuit more complex than that illustrated in Fig. 2A. However, if the circuitry of Fig. 2A responded in the manner as indicated by the dotted line 82 in Fig. 2B, this circuitry would, in accordance with the present method, be said to have failed. On the other hand, it would be possible for the circuitry of Fig. 2A to respond to the change at the primary input pin prior to the 18 ns established as the maximum delay for signal paths in this class and be considered to be good in accordance with the present invention. Indeed, so long as primary output response to a primary input stimulus occurs prior to the maximum acceptable delay for that class of circuit path TD(max), the circuit is said to have passed the delay test of the present invention. By defining the test in this manner, propagation delay testing for primary input to primary output pin delay is simplified as such delay need only be checked against one maximum delay TD(max).

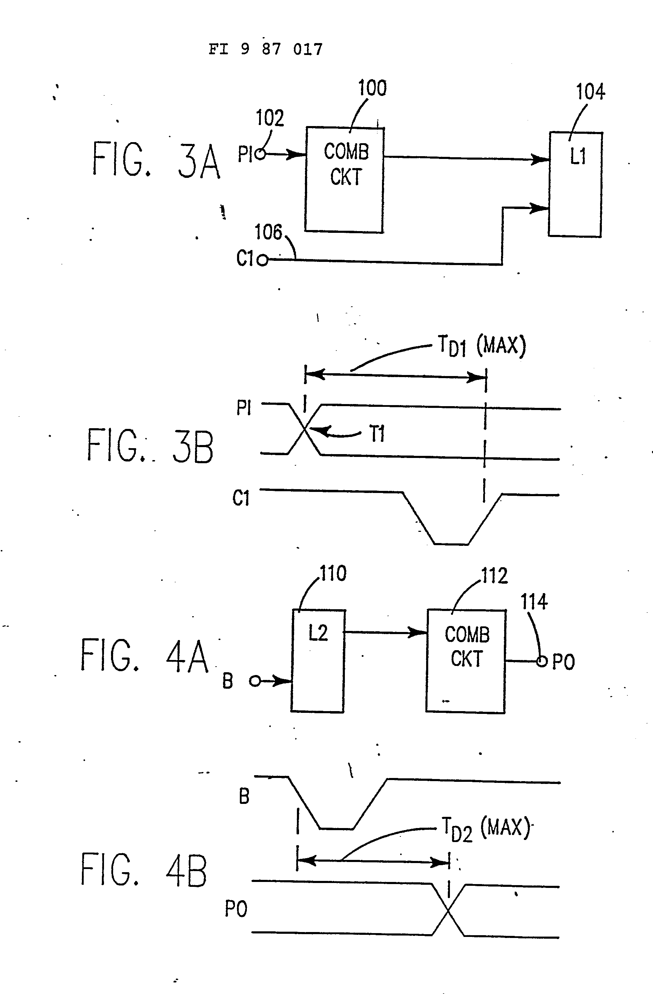

As it was believed that delay measurement for only one signal path class would not provide sufficient coverage for determining whether a chip would fail in its operative environment, it was believed that a plurality of different signal path classes needed to be defined, the maximum propagation delay needed to be determined and measurements needed to be performed thereon. Fig. 3A illustrates a second class of circuit path having an associated delay therewith. This class of circuit path includes one or more circuit elements within the combinational network 100 which comprises a portion of the circuitry within a network 12 of Fig. 1. This combinational network 100 is coupled at its input to a primary input pin 102. The output of the combinational circuit 100 is coupled to the latch L1 indicated at 104 which comprises the L1 latch for a particular position in the scan register 15. The data appearing at the input to the latch L1 104 is gated into this latch via a gating signal appearing on the line 106. For the circuit illustrated in Fig. 3A, the timing diagram of Fig. 3B applies. In this illustration, the primary input at 102 can change state at a time T1. By appropriate selection of the timing of the gating signal on the line 106, the midpoint of the leading edge thereof being used to trigger the latch 104, the signals from the primary input pin are converted by the combinational circuit 100 and latched into the latch L1 104.

The circuit of Fig. 3A represents a second class of signal path for which a delay can easily be measured. This signal path class is characterized by the delay between applying signals to the primary input pin until resulting signals appear at the input to the L1 latch 104. This delay is primarily due to the delay associated with the internal logic of the circuitry disposed between pin 102 and the input to latch 104. By analyzing the actual chip design, the maximum expected delay TD(max) for this class of delay can be determined.

In order to test the chip to determine whether any delay in this class of delay has exceeded the maximum TD1(max), the timing of the leading edge of the gate signal C1 must be adjusted so its midpoint occurs TD1(max) after the midpoint of data changes at the primary input pin 102. By applying test patterns to the input to the chip and scanning the data from the scan register, if the scan register data is not as expected, a delay in this class of delay has occurred which exceeds the maximum expected delay and the chip should be discarded.

Another class of circuit path is illustrated by the circuitry of Fig. 4A and particularly relates to the delay associated with gating data from the latch L2 110 via a combinational circuit 112 to a primary output pin 114. A delay for this class of signal path comprises the time it takes for the signal to propagate from the output of the latch 110 until a corresponding signal appears at the primary output pin 114. Fig. 4B illustrates the timing signals on the lines labeled B and PO. The delay associated with propagation through the combinational circuit 112 is illustrated in Fig. 4B as TD2(max). Again, based upon the particulars of the combinational circuit 112, for the particular chip in question, a maximum delay associated with that signal path is defined. By using conventional delay measurement techniques, the actual delay TD2 (max) can be measured and if this measured delay exceeds the maximum calculated delay for any delay in this signal path class, the tested circuit is deemed to be defective and should be discarded.

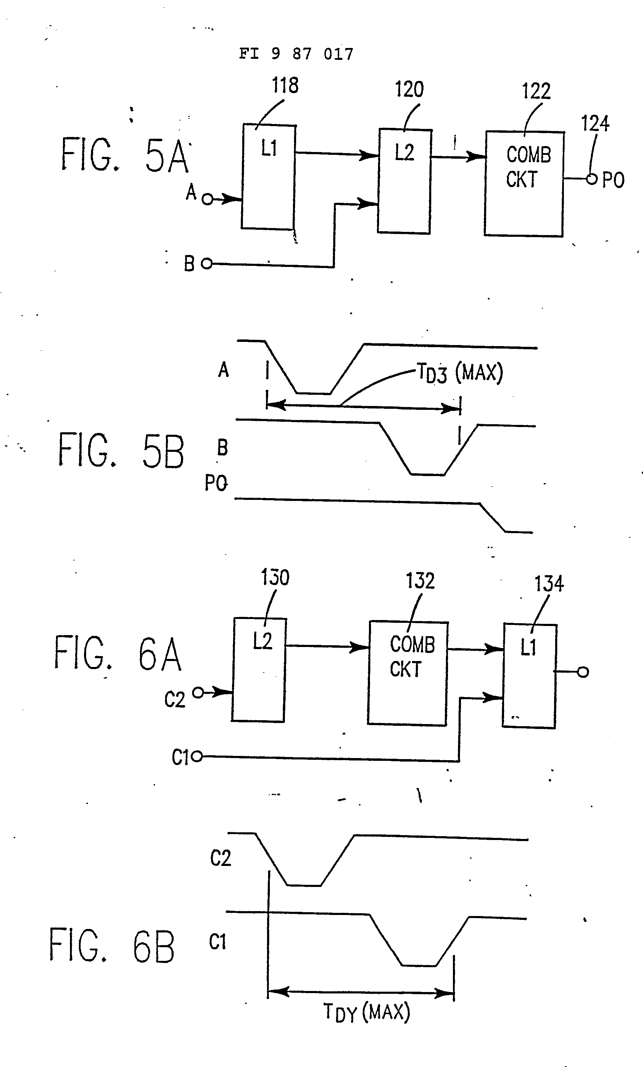

A fourth class of circuit path is illustrated in Fig. 5A and has a path delay between the time data is gated from the latch L1 118 until it arrives at latch L2 120. This delay is important as it determines whether the elements of the scan register are functioning properly together. Good results from this test are determined by subsequently gating data from the L2 latch 120 via a combinational network 122 to a primary output pin 124 or, in the alternative, gating data from the L2 register via the scan register shift output approach and in determining whether the data appearing in each L2 latch position was correct. If the data was correct, then the transfer from the L1 latch 118 to the L2 latch 120 operated correctly. The gating signals A and B are timed with respect to each other so that the maximum delay expected between transfer from L1 latch to L2 latch TD3(max) is as illustrated in Fig. 5B. Then, if the actual data from the L2 latch 120 is different from that which is expected, then the circuit is said to have exceeded the maximum acceptable delay for this class and it should be discarded.

A fifth class of signal path is illustrated by the circuitry of Fig. 6A. This class of circuit path has a delay associated therewith which occurs in the combinational logic 132 disposed between an L2 latch 130 and an L1 latch 134. As illustrated in Fig. 6B, the leading edge of the C2 gating signal gates the data from the L2 latch 130 into the combinational logic 132. After a propagation delay, the gating signal C1 gates the signal into the L1 latch 134. The relationship of the gating signals C1 and C2 is established so that TD4(max) is the maximum acceptable delay for any signal path through the combinational circuit 132 for the chip design in question. Then, after each test of the chip, tests on the data in the scan register will determine whether the maximum acceptable delay for this class of circuit path has been exceeded.

It should be noted that the above discussion and the claims relate to testing a chip. Those of skill in the art will readily recognize that a plurality of chips could be wired together in a multi-chip configuration which will appear to the tester as a single large chip. The resulting configuration may have one scan register spanning over all the chips. Alternatively, the scan register of each chip may remain directly accessible. Other variations are possible as well. The testing method of the present invention, however, will be effective for any of these modifications to the circuitry under test.

Other classes of delay are usable in delay testing. For example, a VLSI chip may include embedded arrays. Under the LSSD design methodology, the array may be coupled, at its input, to primary input pins, other internal logic paths or to an L2 latch. A failure associated with each of these paths can be determined by attempting to place data into the array and controlling the gating pulses associated therewith. Then the array data can be scanned out to see if it is correct. When the scanned data is incorrect, the delay associated with the path under test is greater than it should be and the part should be disposed of.

Further signal path classes may be defined which correspond to paths between the array and, for example, either an L1 latch or a primary output pin. In the case of the array to L1 signal path, the clocks are adjusted so that the maximum design delay between gating the data from the array until it is gated in to latch L1 occurs. If the data read from the LSSD scan register is incorrect, then the maximum array to latch L1 delay has been exceeded. In the case of a delay between the array and a primary output, the data is gated from the array and its arrival is measured at the output pin. If the delay exceeds the maximum design delay, the part should be discarded.

While there has been shown and described what is considered at present to be the preferred embodiment of the present invention, it will be appreciated by those skilled in the art that modifications of such embodiment may be made. It is, therefore, desired that the invention not be limited to this embodiment, and it is intended to cover in the appended claims all such modifications as fall within the true spirit and scope of the invention.

## Claims

1. A method for delay testing a VLSI chip or the like designed using LSSD or functionally equivalent scan design rules, said chip having primary inputs, primary outputs, internal logic between said primary inputs and said primary outputs and a multi-position scan register with each position having an input and an output and a scan input and a scan output, the method comprising the steps of:
identifying at least two classes of signal paths selected from a plurality of classes of signal paths including but not limited to the signal path from primary input pin to primary output pin, the path from primary input pin to scan register, the path from scan register to primary output pin and the path from scan register to scan register via internal logic;
determining from the specific design of the VLSI chip the maximum acceptable delay for signals on each identified class of paths;
applying a plurality of test patterns to said chip; and determining whether any delay measured for signals on each class of identified path exceeds said maximum acceptable delay for that class whereby any chip having a measured delay for any identified class of paths exceeding the maximum acceptable delay for that class is identified as a failing chip.

2. The method of claim 1 wherein at least three classes of paths are identified.

3. The method of claim 1 wherein at least four classes of paths are identified.

4. The method of claim 1 wherein one identified class of signal path is the path from the primary input pins to the primary output pins.

5. The method of claim 1 wherein said plurality of classes of paths additionally includes the path from one latch in one position in the scan register to another latch in the same position in the scan register.

6. The method of claim 1 wherein said plurality of test patterns comprises a plurality of test patterns selected to test for dc stuck faults.

7. The method of claim 1 wherein one identified class of path is the signal path from a position in the scan register via internal logic to a position in the scan register.

8. The method of claim 1 wherein determining the delay for at least one identified class of path includes setting of the gating clocks for the chip so that, in the event that the maximum acceptable delay is exceeded, the data expected at least at one primary output pin or one scan register position is not as predicted for the chip in response to at least one test pattern being applied to the chip.

9. A method for delay testing a VLSI chip or the like designed using LSSD or functionally equivalent scan design rules, said chip having a plurality of primary inputs, a plurality of primary outputs, internal logic coupled between the primary inputs and the primary outputs and a multi-position scan register with at least two latches in each scan register position, the method comprising the steps of:
determining for the specific VLSI chip design the maximum acceptable delay between applying any signal pattern to said primary inputs until the last signal resulting therefrom appears at any said primary output;
determining for the specific VLSI chip design the maximum acceptable delay between gating signals from the scan register into said internal logic until the last output signal resulting therefrom appears at one said primary output;
determining for the specific VLSI chip design the maximum acceptable delay between signals being applied to said primary inputs until the last signal resulting therefrom arrives at said scan register via said internal logic;
determining for the specific VLSI chip design the maximum acceptable delay between signals being gated from said scan register until the last signal resulting therefrom arrives at said scan register via said internal logic;
measuring, for a plurality of test patterns, the actual delay for the VLSI chip between applying said test pattern to said primary inputs and the time the last signal resulting therefrom appears at any said primary output;
measuring, for a plurality of test patterns, the actual delay between gating signals from said scan register into said internal logic until the last output signal resulting therefrom appears at one said primary output;

measuring, for a plurality of test patterns, the actual delay between applying signals to said primary inputs until the last signal resulting therefrom appears at any input to said scan register;

measuring, for a plurality of test patterns, the actual delay between gating signals from said scan register until the last signal arrives via said internal logic at said scan register; and

discarding any chip having an actual delay measured which exceeds the corresponding determined maximum acceptable delay.

10. A method for delay testing a VLSI chip or the like designed using LSSD or functionally equivalent scan design rules, said chip having a plurality of primary inputs, a plurality of primary outputs, internal logic coupled between the primary inputs and the primary outputs and a scan register having a plurality of positions, each position being coupled to either a primary input, a primary output or a point in the internal logic, the method comprising the steps of:

defining a plurality of signal paths from the circuit design and layout of a VLSI chip, each signal path being characterized in that the input and output of each signal path is externally testable while the circuits disposed between the input and output of a signal path may not be externally testable;

determining from the circuit diagram and the circuit layout of a VLSI chip the maximum acceptable delay between the time when a signal pattern is applied to the input of any said class of signal paths and the time when the last signal appears at the output of the class of signal paths to which the input was applied;

measuring the delay between the time when an input pattern is applied to the input of any said class of signal paths until the last output resulting therefrom appears at an output of the signal path to which an input was applied;

comparing the measured delay between the time when an input pattern is applied to the input of any said class of signal paths until the last output resulting therefrom appears at an output of the signal path to which an input was applied with the determined maximum delay for that path and discarding the VLSI chip if the measured delay is greater than the determined maximum acceptable delay for the class of signal path to which the input pattern was applied.

FI 9 87 017

FIG. 1

FIG. 2A

FIG. 2B

FI 9 87 017

FIG. 3A

100

102
PI → COMB CKT

104
L1

106
C1

FIG. 3B

T$_{D1}$ (MAX)

PI

T1

C1

FIG. 4A

110
L2

112
COMB CKT

114
PO

B

FIG. 4B

B

T$_{D2}$ (MAX)

PO

FI 9 87 017

**FIG. 5A**

118 · L1
120 · L2
122 · COMB CKT
124 · PO

A
B

**FIG. 5B**

A

$T_{D3}$ (MAX)

B

PO

**FIG. 6A**

130 · L2
132 · COMB CKT
134 · L1

C2
C1

**FIG. 6B**

C2

C1

$T_{DY}$ (MAX)